# EUROPÄISCHE PATENTSCHRIFT

(11) **EP 1 334 466 B1**
(45) Veröffentlichungstag und Bekanntmachung des Hinweises auf die Patenterteilung: **23.04.2008**
(21) Anmeldenummer: 01996831.2
(22) Anmeldetag: 16.11.2001
(51) Int. Cl.: G06N 1/00

(54) **VERFAHREN UND ANORDNUNG ZUR VERARBEITUNG VON QUANTENMECHANISCHEN INFORMATIONSEINHEITEN**
METHOD AND ASSEMBLY FOR PROCESSING QUANTUM-MECHANICAL INFORMATION UNITS
PROCEDE ET DISPOSITIF POUR LE TRAITEMENT D'UNITES D'INFORMATIONS EN MECANIQUE QUANTIQUE

(30) Priorität: 19.11.2000 DE 10058243
(43) Veröffentlichungstag der Anmeldung: 13.08.2003
(73) Patentinhaber: Hahn-Meitner-Institut Berlin Gesellschaft mit beschränkter Haftung, 14109 Berlin (DE)
(72) Erfinder: HARNEIT, Wolfgang, 10589 Berlin (DE); DINSE, Klaus-Peter, 69121 Heidelberg (DE); MERTESACKER, Bernd, 13503 Berlin (DE); WAIBLINGER, Markus, 10553 Berlin (DE); WEIDINGER, Alois, 14129 Berlin (DE)
(74) Vertreter: Rudolph, Margit
(86) Internationale Anmeldenummer: PCT/DE2001/004381
(87) Internationale Veröffentlichungsnummer: WO 2002/041247

(56) Entgegenhaltungen:
- EP-A- 0 591 595
- WO-A-00/30255
- HARNEIT W ET AL: "N C/sub 60/ for quantum computing" ELECTRONIC PROPERTIES OF NOVEL MATERIALS - MOLECULAR NANOSTRUCTURES. 14TH INTERNATIONAL WINTERSCHOOL/EUROCONFERENCE, KIRCHBERG, AUSTRIA, 4-11 MARCH 2000, Nr. 544, Seiten 207-210, XP002196473 AIP Conference Proceedings, 2000, AIP, USA ISSN: 0094-243X
- WAIBLINGER M ET AL: "Magnetic interaction in diluted N C/sub 60/" ELECTRONIC PROPERTIES OF NOVEL MATERIALS - MOLECULAR NANOSTRUCTURES. 14TH INTERNATIONAL WINTERSCHOOL/EUROCONFERENCE, KIRCHBERG, AUSTRIA, 4-11 MARCH 2000, Nr. 544, Seiten 195-198, XP002196949 AIP Conference Proceedings, 2000, AIP, USA ISSN: 0094-243X

## Beschreibung

Die Erfindung bezieht sich auf ein Verfahren zur Verarbeitung von quantenmechanischen Informationseinheiten durch deren Kodierung in der Spinstellung, die in einem äußeren Magnetfeld durch eingestrahlte elektromagnetische Pulse in Resonanzfrequenz beeinflussbar ist, von lokal einem Substrat zugeordneten, adressierbaren Spins mit einer Steuerung der Resonanzfrequenz der einzelnen Spins und der elektromagnetischen Kopplung zwischen benachbarten Spins. Die Erfindung bezieht sich weiterhin auf eine Anordnung in Form eines spinbasierten Quantencomputers zur Durchführung des Verfahrens mit lokalen Adressier-Steuerzugängen zur Steuerung der Resonanzfrequenz der einzelnen Spins und lokalen Kopplungs-Steuerzugängen zur Steuerung der elektromagnetischen Kopplung zwischen benachbarten Spins.

Quantenmechanische Informationsverarbeitung ist ein sehr junges Gebiet (vgl. Übersichtsartikel "Quantum information and computation" C.H. Bennett, D.P. DiVincenzo, Nature / Vol 404 / 16. March 2000 / pp 247-255). Ein Untergebiet beschäftigt sich mit der Verarbeitung der quantenmechanischen Informationseinheiten (sogenannte "Qubits") durch deren Kodierung in den einzelnen Spinstellungen in Spin-Quantencomputern. Die Informationen werden bei dieser Art von Computern in einem äußeren Magnetfeld durch elektromagnetische Pulse mit Resonanzfrequenz übertragen (Phänomen der magnetischen Resonanz, bekannt z.B. aus der Kernspin-Tomographie). Einige Realisierungen von Spin-Quantencomputern sind in der Literatur beschrieben worden (vgl. z.B. Bennett und DiVincenzo, a.a.O.), jedoch sind die meisten davon Flüssigkeits-Quantum Computer, bei denen die informationstragenden Kernspinsysteme in flüssiger Phase vorliegen. Bei derartigen Quantencomputem ist keine lokale, dynamische Kontrolle der Spins durch lokale Steuerzugänge möglich. Daher wird die Information bei Einstrahlen eines elektromagnetischen Pulses grundsätzlich auf alle Spins mit gleicher Resonanzfrequenz gleichzeitig übertragen. Es müssen daher spezielle Moleküle verwendet werden, in denen die aktiven Kernspins durch ihr lokales Umfeld eine statisch unterschiedliche Resonanzfrequenz besitzen. Die für die eigentliche Informationsverarbeitung notwendige Kopplung der Spins untereinander ist bei diesen Computern unveränderlich durch das Molekül vorgegeben.

Wesentlich leistungsfähiger als Flüssigkeits-Quantencomputer sind Festkörper-Quantencomputer mit lokalen Steuerzugängen. Diese Quantencomputer basieren in bekannten Ausführungsformen nicht auf der vorgegebenen Architektur eines Moleküls, sondern auf der Anordnung der Spins durch Methoden der Nanostrukturierung von Festkörpern, wie sie z.B. aus der Halbleitertechnologie bekannt sind. Lokale Steuerzugänge erlauben hier die dynamische Modifikation der Resonanzfrequenz einzelner Spins sowie der Kopplung der Spins untereinander. Dadurch sind mehr Freiheitsgrade beim Design der Computer möglich, und insbesondere die Skalierbarkeit der Konzepte von wenigen auf viele Qubits ist gegeben. Durch die Steuerung der Adressierung der Spins wird deren Ansprechbarkeit festgelegt. Nur Spins mit der Resonanzfrequenz sind ansprechbar. Wird die Resonanzfrequenz durch Steuerungsmaßnahmen verstellt, ist der entsprechende Spin "abgeschaltet" und durch die ursprüngliche Resonanzfrequenz nicht mehr ansprechbar. Durch die Steuerung der Kopplung zwischen benachbarten Spins kann der Rechenvorgang beeinflusst werden. Insbesondere ist eine Abschaltung der Kopplung während der Einstellung der Spins und nach dem Rechenvorgang bei der Auslesung möglich. Unter "benachbarten Spins" soll in diesem Zusammenhang sowohl eine direkte Nachbarschaft zweier Spins als auch eine indirekte Nachbarschaft von mehreren nebeneinander angeordneten Spins verstanden werden.

Ein Verfahren zur Spinstellung-Kodierung mit einer Steuerung der Resonanzfrequenz der einzelnen Spins und der elektromagnetischen Kopplung zwischen benachbarten Spins und eine entsprechende Realisierung von elektronischen Steuerzugängen ist aus der W09914858 bekannt (vgl. auch "A silicon-based nuclear spin quantum computer" B.E. Kane, Nature / Vol 393 / 14. May 1998 / pp 133-137). Als Qubit wird hier der Kernspin einzelner Phosphoratome in Silizium verwendet. Das Verfahren beruht auf der Ankopplung des zur Kodierung genutzten Kernspin-Systems durch die Beeinflussung seiner Elektronenumgebung mittels steuerbarer elektrischer Felder. Zur Steuerung der Resonanzfrequenz der einzelnen adressierbaren Kernspins wird die Hyperfeinkopplung eines einzelnen Kernspins mit seinem Valenzelektron durch das Anlegen eines elektrischen Feldes direkt verändert. Dazu wird der Adressierungs-Steuerzugang als Elektrode ausgeführt, genau über einem Phosphoratom positioniert und an eine Steuerspannung angeschlossen. Im Fall der Steuerung der elektromagnetischen Kopplung zwischen benachbarten Kernspins wird wiederum durch das lokale Anlegen eines elektrischen Feldes die Austauschwechselwirkung zwischen benachbarten Kernspins verändert. Dazu wird ein ebenfalls als Elektrode ausgebildeter Kopplungs-Steuerzugang, der örtlich genau zwischen den wechselwirkenden Kernspins angeordnet sein muss, mit einer Steuerspannung beaufschlagt. Eine Schwierigkeit bei diesem bekannten Verfahren und seiner Realisierung ist, dass die steuernde Beeinflussung der verschiedenen Kopplungen durch die elektronischen Steuerzugänge sehr gering ist. Dadurch werden extrem hohe Ansprüche an die technische Realisierung der Steuerzugänge gestellt, insbesondere bezüglich der Platzierung einzelner Phosphoratome an definierten Stellen im Inneren des Siliziumsubstrats. Ferner sind die Abmessungen der als Elektroden mit Abmessungen in Bereich nur einiger Nanometern ausgeführten Steuerzugänge derzeit technisch noch nicht realisierbar.

Aus den genannten Gründen besteht also bei Spin-Quantencomputern die Notwendigkeit, zum einen einen bestimmten Informationsträger selektiv anzusprechen (Adressierung über die gesteuerte Änderung der Spin-Resonanzfrequenz), und zum anderen die Kopplung zwischen den Informationsträgern gezielt ein- und auszuschalten bzw. in der Stärke zu modifizieren (Steuerung der Spin-Kopplung). Die **P**roblematik für die vorliegende Erfindung ist daher darin zu sehen, ein besonders leistungsfähiges und effizientes Verfahren mit einer großen Flexibilität angeben zu können. Eine bevorzugte Anordnung zur Verfahrensdurchführung soll dabei die Flexibilität in einfacher Weise nachvollziehen können. Insbesondere sollen jedoch mit dem erfindungsgemäßen Verfahren und der realisierenden Anordnung die bei dem bekannten Verfahren und seiner Realisierung aufgezeigten Schwachstellen vermieden werden.

Als **L**ösung für diese Problematik ist bei einem **V**erfahren der eingangs genannten Art zur Verarbeitung von quantenmechanischen Informationseinheiten mit einer Steuerung der Resonanzfrequenz der einzelnen Spins und der elektromagnetischen Kopplung zwischen benachbarten Spins deshalb vorgesehen, dass zur Informationsverarbeitung der adressierbare Elektronenspin ungebundener Einschlussatome im Käfiginnenraum von endohedralen Fullerenen genutzt wird, der mit den Elektronenspins benachbarter Einschlussatome über magnetische Dipol-Dipol-Wechselwirkung in Kopplung steht, und dass die Steuerung der Resonanzfrequenz der Elektronenspins durch einen kontrollierten Elektronentransfer zum oder vom Käfig der endohedralen Fullerene mit einstellbarer Verweildauer und/oder die Steuerung der elektromagnetischen Kopplung durch eine kontrollierte Winkeländerung zwischen der Orientierung des äußeren Magnetfeldes und dem Verbindungsvektor benachbarter Fullerene erfolgt.

Weiterhin ist bei einer **A**nordnung in Form eines spinbasierten Quantencomputers zur Verfahrensdurchführung zur Problemlösung vorgesehen, dass die adressierbaren Spins von Elektronenspins ungebundener Einschlussatome im Käfiginnenraum von endohedralen Fullerenen gleicher oder unterschiedlicher Ausführung gebildet werden, die unter Einbeziehung des Substrats mit einem vorgegebenen Abstand und einer relativen Lage zueinander in einer Matrix mit zwei- oder dreidimensionaler Ausprägung fest miteinander verbunden sind, und dass die Adressier- und/oder Kopplungs-Steuerzugänge konstruktiv entsprechend der gewählten Form der Steuerung der Resonanzfrequenz der einzelnen Spins und der elektromagnetischen Kopplung zwischen benachbarten Spins ausgeführt sind.

Vorteilhafte Weiterführungen und Weiterbildungen des erfindungsgemäßen Verfahrens und der bevorzugten Anordnung sind den entsprechend nachgeordneten Unteransprüchen zu entnehmen. Dabei wurden die Begriffe "Adressier-Steuerzugang" und "Kopplungs-Steuerzugang" im Sinne in einer allgemeinen Zugänglichkeit zu den entsprechend zu steuernden Orten gewählt ("Zugang haben"). Die Realisierungen dieser Zugänge können je nach Wahl der Steuerungsart unterschiedlichster Natur sein und von elektrischen Zugängen, beispielsweise in Form von einfachen flächigen Elektroden, bis zu optischen, thermischen und chemischen oder auch auf andere Weise arbeitenden Zugängen reichen.

Ein wesentliches Merkmal des erfindungsgemäßen Verfahrens ist die Nutzung von Elektronenspinsystemen zur Informationsverarbeitung gegenüber der bekannten Nutzung von Kernspinsystemen, die eine relativ geringe Empfindlichkeit aufweisen. Als Elektronenspinsysteme werden stabile endohedrale Fullerene benutzt. Fullerene sind käfigartige Moleküle, die aus Kohlenstoffatomen bestehen. Am bekanntesten ist das C₆₀-Molekül. Im Inneren dieser Moleküle lassen sich durch verschiedene Verfahren Atome oder Moleküle einschließen. Die so gebildeten Moleküle werden dann endohedrale Fullerene genannt. Bei den für das erfindungsgemäße Verfahren einsetzbaren endohedralen Fullerenen ist das eingeschlossene Atom nicht an die Innenseite des Fullerens gebunden, sondern frei in der Käfigmitte positioniert, wodurch sich für die Anwendung günstige Eigenschaften für den Elektronenspin des eingeschlossenen Atoms ergeben (vgl. EP0958241**).** Durch die sehr gute Abschirmung des Elektronenspins von seiner Umgebung ergibt sich eine lange Kohärenzzeit, in der der Zustand aller relevanten Spins phasenkohärent bleibt.

Außerdem besitzen die hier verwendeten endohedralen Fullerene magnetische Dipole, die die Möglichkeit einer magnetischen Dipol-Dipol-Kopplung zu benachbarten Elektronenspins eröffnen und quantenmechanisches Rechnen ermöglichen.

Bei dem erfindungsgemäßen Verfahren können durch die Benutzung des Elektronenspinsystems zwei Konzepte zum Quantenrechnen verwirklicht werden : Zum einen kann die gesamte Datenverarbeitung in Form von Ein- und Ausgabe, Rechnung und Speicherung nur mit den Elektronenspins stattfinden. Die Kernspins können in diesem Falle ignoriert oder deaktiviert werden. Zum anderen können die Kernspins in Erweiterung des ersten Konzepts zur Langzeit-Speicherung von Zwischenergebnissen herangezogen werden. Da die Kernspins noch längere Kohärenzzeiten als die Elektronenspins aufweisen, können sie als "integrierte Quanten-Festplatte" benutzt werden. Schnelle Rechenzeiten sind jedoch erforderlich, um der zunehmenden Inkohärenz durch die Elektronenspins mit der etwas geringeren Kohärenzzeit zuvorzukommen. Weitere Vorteile eines elektronenspinbasierten Systems sind die stärkere Polarisierbarkeit der Elektronenspins bis zur vollständigen Polarisation, wodurch aufwändige Initialisierungsroutinen zum Prozessbeginn zur Überprüfung der Spinzustände entfallen, wie sie beispielsweise aus der oben zitierten W09914858 bekannt sind, und die mit der stärkeren Polarisierbarkeit verbundene wesentlich höhere Empfindlichkeit der Elektronenspinresonanz (ESR) im Vergleich zur Kernspinresonanz (NMR), was zu einer verbesserten Signaldetektierbarkeit führt.

Bei dem anderen wesentlichen Merkmalskomplex des erfindungsgemäßen Verfahrens handelt es sich um die Art der Steuerung der Adressierung der einzelnen Spins und der Kopplung zwischen benachbarten Spins. Durch den kontrollierten Übertrag eines oder mehrerer Elektronen auf das endohedrale Fulleren wird dessen Spinsystem stark verändert, indem entweder eine starke Verschiebung der Resonanzlinie erfolgt oder diese extrem stark verbreitert wird, sodass sie auf eine eingestrahlte Frequenz nicht mehr anspricht. Es ist also möglich, durch einen Elektrontransfer auf das Fulleren die Ansprechwahrscheinlichkeit des Elektronenspins auszuschalten und damit seine Adressierung zu steuern.

Aus dem Aufsatz "Synthesis and EPR studies of N@C₆₀ and N@C₇₀ radical anions" von P. Jakes et al. (XIVth International Winterschool on Electronic Properties of Novel Materials, Kirchberg (Austria) 2000) ist es zwar bekannt, dass C₆₀ Moleküle ein oder mehrere Elektronen aufnehmen können (Funktion als elektronische Akzeptoren) und dass dadurch ein neuer Zustand entsteht, der zu einer Verschiebung der Resonanzfrequenz des eingeschlossenen Atoms führt (Verschwinden der ESR-Resonanzlinie von N@C₆₀ bei Elektronentransfer). Schlüsse oder Hinweise für eine Nutzung wurden jedoch aus dieser Erkenntnis nicht gezogen. Auch eine Umsetzung der Steuerung der Kopplung zwischen benachbarten Spins über eine Änderung des Winkels bei Dipol-Dipol-Kopplung ist aus der Literatur nicht bekannt. Jedoch sind die Erkenntnisse über das Verhalten von Dipolfeldern in übergeordneten Magnetfeldern allgemein bekannt und dem physikalischen Grundwissen zuzuordnen. Der Elektronenspin hat ein magnetisches Dipolmoment, das ein schnell mit der Entfernung abfallendes Magnetfeld erzeugt. Dieses Feld wirkt auf jeden benachbarten Elektronenspin (Dipol-Dipol.Kopplung oder auch Dipol-Dipol-Wechselwirkung). Die Geometrie des Dipolfeldes hat zur Folge, dass die Kopplungsstärke zwischen zwei Qubits ausgeprägt vom Winkel zwischen der Verbindungslinie der Fullerene und der Ausrichtung des erzeugenden Dipols abhängt. Insbesondere gilt Kopplungsstärke J = 0 bei dem "magischen" Winkel von 54,7°. Hingegen ist die Kopplung J maximal, wenn dieser Winkel Null ist. Die Ausrichtung der Elektronenspins folgt der Orientierung des von außen angelegten Magnetfeldes (gleich oder gegengleich). Durch die kontrollierte Einstellung des Winkels zwischen der Verbindungslinie zweier Fullerene und der Orientierung des äußeren Magnetfeldes kann daher bei dem erfindungsgemäßen Verfahren die Stärke der Dipol-Dipol-Kopplung zwischen Null und einem Maximalwert kontrolliert gesteuert bzw. geschaltet werden.

Bei der Steuerung der Adressierung der Spins und ihrer Kopplung besteht neben der Durchführung eines einmaligen Steuervorgangs, beispielsweise für eine Initialisierung oder Rückstellung, auch die Möglichkeit, eine getaktete Steuerung durchzuführen. Die Steuerung in einem vorgegebenen Arbeitstakt ist in Analogie zum Zeittakt für klassisches Elektronikrechnen zu sehen, der einen optimalen Rechenablauf mit höchstmöglicher Synchronität ermöglicht.

Die Realisierung des erfindungsgemäßen Verfahrens erfolgt in einem Spin-Quantencomputer. Dazu werden mehrere endohedrale Fullerene als Basisbausteine in einer wählbaren Relation zueinander angeordnet, wodurch eine Festkörperstruktur mit einem geometrisch wohldefinierten Spinsystem zur Verfügung gestellt wird. Es können dabei je nach Ausführung gleiche oder verschiedene endohedrale Fullerene verwendet werden, wodurch insbesondere die statische Adressierbarkeit verschiedener Klassen von Qubits, die durch ein identisches lokales Umfeld charakterisiert sind, vorgegeben werden kann. Durch Wahl des Abstands und der relativen Lage der Fullerene zueinander kann eine statische Voreinstellung der Kopplung zwischen den Qubits erreicht werden. Verschiedene natürlich vorkommende Gruppe-V-Elemente (¹⁴N, ¹⁵N, ³¹P) können im Fulleren eingeschlossen werden. Außerdem lässt sich das Fullerenmolekül variieren (C₇₀ statt C₆₀) oder chemisch durch Adduktbildung unter Anbringung chemischer Gruppen (Addenden) modifizieren. Dadurch stehen verschiedene, individuell designte Moleküle mit jeweils charakteristischer Resonanzfrequenz als statisch unterscheidbare Qubits zur Verfügung. Durch die Möglichkeit, Dimere von Fullerenen (Fulleren-Oligomere) bzw. Fulleren-Polymere (allgemein Fulleren-Systeme)herzustellen, können weiterhin Strukturen mit definierter Dipolkopplung zwischen darin eingebauten Elektronenspins realisiert werden. Da die Zahl der beteiligten Spins im Prinzip frei wählbar ist, können damit lineare, flächige und räumliche Qubitsysteme beliebiger Größe erzeugt werden. Außerdem können auf diesem Wege viele identische Qubitsysteme in einem Schritt realisiert werden, wie es für Auslesevorgänge günstig sein kann. Falls die Fulleren-Oligomere orientiert in eine entsprechende Matrix eingebaut werden, erhält man ein multiples, n-dimensionales Qubit-Festkörpersystem.

Für die Anordnung solcher Fulleren-Systeme, die auch durch chemische Verknüpfung der Fullerene miteinander hergestellt werden können, bestehen wiederum unterschiedliche Möglichkeiten. In der Grundausführung können sie als lineare Kette mit regelmäßigem Abstand der einzelnen Fullerene untereinander gestaltet sein, da dann der Verbindungsvektor zwischen benachbarten Fullerenen denselben Betrag und dieselbe Richtung aufweist. Damit ist es möglich, den "magischen Winkel" zur Ausrichtung der Magnetfelder gleichzeitig für alle Elektronenspins zu wählen, sodass eine totale Entkopplung aller Spins eintritt. In einer Variante lässt man Gitter mit regelmäßiger Wabenstruktur zu, an deren Knotenpunkte die Fullerene angeordnet sind. Die Waben können beliebig, aber insbesondere auch rechteckig (damit sind auch die Knoten "rechteckig") oder dreieckig beschaffen sein. Für jede Konfiguration sind dann unerwünschte Kopplungen durch entsprechende eingestrahlte Pulsfolgen wieder rückgängig zu machen. In einer anderen Variante kann man Gitter zulassen, in denen entlang einer Masche mehrere Fullerene wiederum in einer linearen Kette angeordnet sind. Dann sind die Ketten in sich total entkoppelbar. Aufgrund der Abstandsabhängigkeit der Wechselwirkung tritt jedoch mit der nächsten Kette keine Wechselwirkung auf, da diese zu weit entfernt angeordnet ist. Weiterhin sind Ausführungen mit gezielt miteinander gekoppelten Ketten und räumliche Anordnungen möglich.

Bei der Steuerung der Adressierung einzelner Elektronenspins durch Veränderung der Resonanzfrequenz eines Qubits wird diese - ohne zusätzliche äußere Maßnahmen - durch die Art und chemische Modifikation des Fullerenmoleküls, die Art des eingeschlossenen Atoms und die Anordnung der benachbarten Qubits zueinander beeinflusst. Bei einer Einbeziehung zusätzlicher äußerer Maßnahmen kann die Resonanzfrequenz durch Übertragung eines oder mehrerer Elektronen auf das Fulleren geändert werden. Dieser Vorgang kann gesteuert werden durch elektronische Kontrolle des Ladungstransfers, durch Wahl der Verweildauer von Elektronen auf den Fullerenen (auch chemisch beeinflusst) und durch optisch selektive Anregung von Ladungsträgem. Durch geeignete Kombination der einzelnen Möglichkeiten können somit sehr differenzierte und komplexe Protokolle für das Rechnen mit dem Quantencomputer realisiert werden. So können insbesondere mehrere statisch unterscheidbare Qubits in eine Gruppe zusammengefasst werden, die gemeinsam mit einem Steuerzugang, beispielsweise in Form einer Elektrode, geschaltet werden. Dadurch können insbesondere die Elektroden größer als die aus dem Stand der Technik bekannten Elektroden mit problematischen Abmessungen im Nanometerbereich ausgelegt werden. Eine gemeinsame Steuer-Elektrode kann z.B. nur den Ladungsabfluss regeln (Sperrdiode), wohingegen der Elektronenzufluss durch optische Anregung ohne eine körperliche Elektrode erzeugt wird. Hierbei wird der Steuerzugang dann entsprechend durch eine regelbare Lichtquelle realisiert.

Nachfolgend werden Beispiele für unterschiedliche Möglichkeiten und Realisierungen des Elektronentransfers auf das Fulleren zur kontrollierbaren Steuerung der Adressierbarkeit des Elektronenspins durch Veränderung der Resonanzfrequenz gegeben.

### • Elektronenübertrag durch ein elektrisches Feld

Als Quelle und Senke der Elektronen kommt die Umgebung der Fullerenmoleküle in Betracht, insbesondere das Substrat oder ein die Fullerene umgebender Elektrolyt. Durch Anlegen einer Steuerspannung können ein oder mehrere Elektronen auf das Fulleren übertragen oder abgezogen werden. Bei Verwendung von Elektrolyten ist zusätzlich auf die Verankerung der Fullerene (z.B. durch Verwendung haftverbessernder Addenden) zu achten.

### • Ankopplung der Fullerene an Donator-Moleküle

Aus der Fullerenforschung ist bekannt, dass Fullerene in Verbindung mit Polymeren für die Trennung von Elektron-Loch-Paaren in photovoltaischen Anwendungen eingesetzt werden können. Der Ladungsübertrag auf ein Fullerenmolekül kann dabei extrem schnell sein (wenige Femtosekunden). Daher ist ein Elektronenübertrag und -abfluss via Zuleitungen auf PolymerBasis möglich, wodurch eine geometrische Entzerrung der Elektrodenstruktur erreicht werden kann. Durch geeignete Wahl der Materialien kann die Verweildauer der Elektronen auf dem Fullerenmolekül eingestellt werden. Gegebenenfalls ist eine direkte chemische Bindung zwischen dem Fulleren und dem Polymer herstellbar.

### • Optisches Schalten durch Anregung von Elektron-Loch-Paaren

Ebenfalls aus der Solarzellenforschung bekannt ist das optische Anregen von Elektron-Loch-Paaren in den oben erwähnten Donatormolekülen. Dadurch ist eine optische Schaltung der Adressiersteuerzugänge möglich. Dabei können insbesondere auch Donatormoleküle mit unterschiedlicher Farbempfindlichkeit, d.h. unterschiedlicher Absorptionswellenlänge zum Einsatz kommen, wodurch ein gleichzeitiges oder gezieltes optisches Schalten einzelner Klassen von Qubits möglich ist.

Nachfolgend werden Beispiele für unterschiedliche Möglichkeiten und Realisierungen für eine Änderung des Winkels der magnetischen Dipol-Dipol-Kopplung zur kontrollierbaren Steuerung der Kopplung zwischen zwei Elektronenspins gegeben.

### • Schaltung durch Verkippen des Substrats oder des äußeren Magnetfeldes

Der einfachste Fall besteht darin, dass alle Qubits in einer linearen Anordnung (Reihe) vorliegen. Dann ist der Verbindungsvektor für alle benachbarten Qubits derselbe. Wenn die Orientierung der Reihe gegenüber dem äußeren Magnetfeld verändert wird (durch Kippen des Substrats oder durch Kippen des Magneten), wird die Kopplung aller Qubits untereinander gleichzeitig verändert. Das Magnetfeld kann dabei insbesondere parallel zur Reihe (maximale Kopplung aller Qubits) oder in einem Winkel von 54,7° dazu liegen ("ausgeschaltete" Kopplung). Auch denkbar ist ein Schalten zwischen den Winkeln 45° ± 9,7°, wodurch die Kopplung zwischen Null und der Hälfte der maximalen Kopplung geschaltet wird, bei einem Mittelwert von einem Viertel der maximalen Kopplung bei 45°. Das Substrat kann ferner in mehrere Bereiche (parallele Reihen mit größerem Abstand als zwischen Qubits in einer Reihe) aufgeteilt sein, die voneinander unabhängig verkippt werden. Insbesondere können hierzu Flüssigkristalle verwendet werden, deren Orientierbarkeit durch elektrische Felder z.B. in LCD-Displays verwendet wird. Statt mechanisch die Orientierung der Verbindungsachse der Qubits gegen das äußere Magnetfeld zu ändern, kann umgekehrt die Orientierung des Magnetfelds geändert werden. Durch Anlegen eines bzgl. des quantisierenden Hauptfelds orthogonalen Zusatzfeldes kann die effektive FeldOrientierung gezielt geändert werden. Dies hat den Vorteil, dass solche Änderungen auf der Mikrosekunden-Zeitskala möglich sind.

### • Schaltung durch Verschieben einzelner Fullerene bzw. Gruppen davon

Einzelne Moleküle oder Molekülgruppen können noch auf eine weitere Weise geschaltet werden: durch eine Verschiebung eines Fullerens entlang des Feldvektors (Spinausrichtung). Hierbei wird nur die Verbindungslinie zwischen zwei Qubits verändert, nicht jedoch die Orientierung des Elektronenspins. Die Verschiebung kann wiederum auf verschiedene Weise erfolgen: durch piezoelektrische Elemente, mechanische Elemente, wie "Mikrorechen" oder STM-Spitzen als Ein- oder Mehrfach-Pinzetten, mechanische Vibrationen des Substrats bei unterschiedlicher Kraftübertragung auf die Fullerenmoleküle (federartige Addenden zwischen Substrat und Fulleren), direkte lokale Anregung von Schwingungsmoden in federartigen Addenden oder Einsatz von Surface Acoustic Waves (SAW) - Bauelementen mit einem kommerziellen Schwingquarz bis Frequenzen > 1 GHz.

**Ausbildungsformen der Erfindung** werden nachfolgend anhand der schematischen Figuren näher erläutert. Dabei zeigen :
- **Figur 1a**: das Schema eines erfindungsgemäßen Elektronenspin-Quantencomputers mit endohedralen Fullerenen im Querschnitt,
- **Figur 1b**: zwei endohedrale Fullerene, deren Elektronenspins über magnetische Dipol-Dipol-Wechselwirkung miteinander gekoppelt sind,
- **Figuren 2**: einen erfindungsgemäßen Elektronenspin-Quantencomputer im Querschnitt mit einem Kopplungs-Steuerzugang zur Veränderung der Kopplungsstärke der Qubits durch :
- **Figur 2a**: Verkippung des Substrates gegenüber der Magnetfeldorientierung,
- **Figur 2b**: Auslenkung eines Fullerens gegenüber seinem Nachbarn,
- **Figur 2c**: Verkippung des äußeren Magnetfeldes gegenüber dem Substrat,
- **Figuren 3**: einen erfindungsgemäßen Elektronenspin-Quantencomputer im Querschnitt mit einem Adressier-Steuerzugang unter Verwendung einer gemeinsamen Adressier-Elektrode für mehrere Qubits, die sich in ihrer statischen Resonanzfrequenz dadurch unterscheiden, dass :

- **Figur 3a**: die Abstände unter den Fullerenen verschieden sind,
- **Figur 3b**: die eingeschlossenen Atome oder die Fullerenkäfige verschieden sind,
- **Figur 3c**: an einem endohedralen Fulleren gleicher Sorte unterschiedliche Addenden angebracht sind, und
- **Figur 4**: einen erfindungsgemäßen Elektronenspin-Quantencomputer mit einem gemeinsamen Adressier-Steuerzugang gemäß Figuren 3a, 3b, 3c in der Draufsicht.

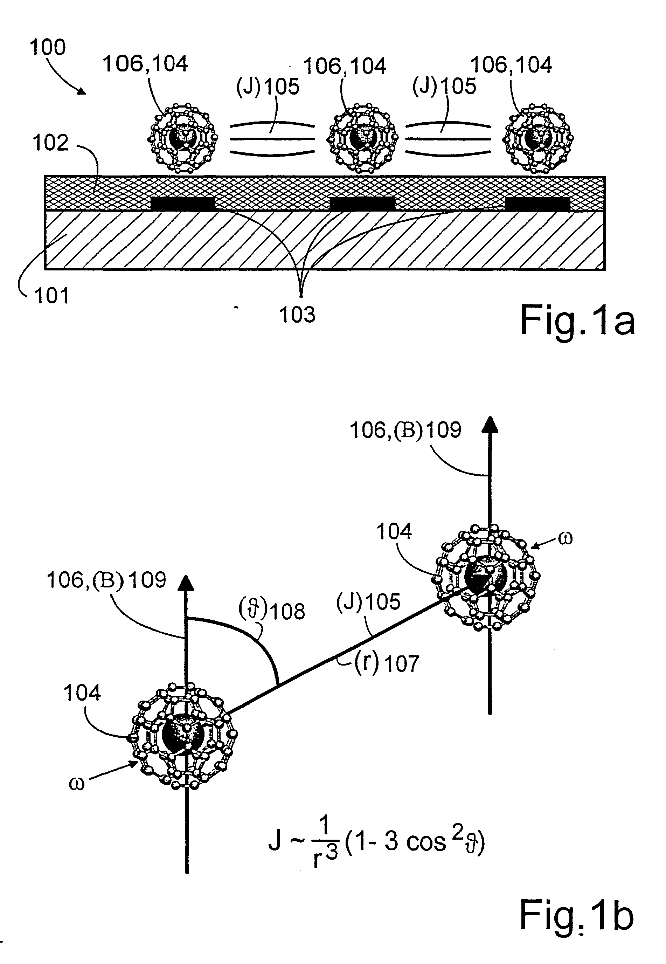

In der **Figur 1a** ist das Schema eines Elektronenspin-Quantencomputers **100** mit endohedralen Fullerenen gezeigt. Auf einem Substrat **101** werden - getrennt durch eine Oxidschicht **102 -** endohedrale Fullerene **104,** im gewählten Ausführungsbeispiel handelt es sich hierbei um **C₆₀ -** Fullerene mit Stickstoff **N** als ungebundenem Einschlussatom **(N@C₆₀),** oberhalb von streifenförmigen Adressier-Elektroden **103,** die einen Adressier-Steuerzugang bilden, angeordnet. Die hier verwendeten endohedralen Fullerene **104** besitzen ein magnetisches Moment, das über magnetische Dipol-Dipol-Wechselwirkung **(J) 105** an das Nachbaratom koppelt. Durch Änderung der magnetischen Kopplung **(J) 105** und/oder Adressierung einzelner Fullerene **104** durch Änderung der Elektronspinresonanzfrequenz aufgrund eine Elektronentransfers auf die Fullerene **104** kann der Elektronenspin-Quantencomputer **100** zur Durchführung von Rechenoperationen gezielt beeinflusst werden.

Die **Figur 1b** zeigt das Schema von zwei endohedralen Fullerenen **104,** deren Elektronenspins **106** über magnetische Dipol-Dipol-Wechselwirkung **(J) 105** miteinander gekoppelt sind. Die Elektronenspins **106** weisen ein magnetisches Dipolmoment auf, das ein schnell mit der Entfernung abfallendes Magnetfeld erzeugt, und sind in der Orientierung eines äußeren Magnetfeldes **(B) 109** gleich (oder auch gegengleich) ausgerichtet. Die Dipol-Dipol-Wechselwirkung **(J) 105** hängt von dem Abstandsvektor **(r) 107** der beiden Fullerenzentren (Einschlussatome) und von dem Winkel (ϑ) **108** zwischen dem Abstandsvektor (r) **107** und der Richtung der Spins **106** über die in der **Figur 1b** angegebene Formel **(J)** ab.

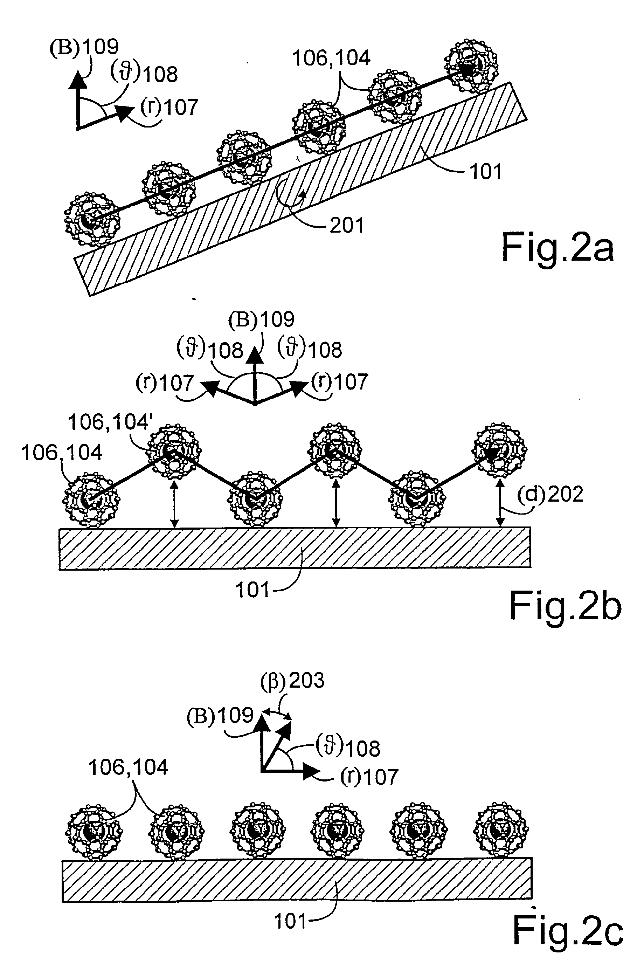

In den **Figuren 2a, 2b und 2c** werden verschiedene Realisierungsmöglichkeiten für den Kopplungs-Steuerzugang zur Veränderung der Kopplungsstärke **(J)** der Qubits gezeigt. Es handelt sich hierbei um absolute und relative Ortslageveränderungen, die durch rein mechanische Maßnahmen, wie beispielsweise Verdrehen, Verkippen oder Anheben, bewirkt werden. Entsprechende Kopplungs-Steuerzugänge sind deshalb in Form von Kipp-Dreh- oder Hebemechanismen ausgestaltet, die den allgemein bekannten Konstruktionsprinzipien folgen können.

In der **Figur 2a** ist eine Änderung der Kopplungsstärke **(J)** der Qubits **106** untereinander durch eine Verdrehung oder Verkippung des Substrates **101** gegenüber der magnetischen Feldorientierung **(B) 109** dargestellt. Eine der **Figur 1a** ähnliche Anordnung von endohedralen Fullerenen **104** auf einem Substrat **101** mit einem Verbindungsvektor in **(r) 107** wird durch eine Verkippung **201** des Substrates **101** bezüglich der Achse des äußeren Magnetfeldes **(B) 109** auf einen bestimmten Winkel (ϑ) **108** eingestellt. Für den Winkel ϑ **= 54,7°** ist die Kopplung **(J)** null, für den Winkel ϑ = **0°** ist die Kopplung **(J)** maximal.

Die **Figur 2b** zeigt eine Änderung der Kopplungsstärke **(J)** der Qubits **106** durch eine Auslenkung eines Fullerens **104'** gegenüber seinem Nachbarn **104**. Jedes zweite der auf dem Substrat **101** angeordneten Fullerene **104'** wird längs der Orientierung des äußeren Magnetfeldes **(B) 109**, d.h. im vorliegenden Fall senkrecht zur Oberfläche des Substrats 101, um einen bestimmten Betrag **(d) 202** gerichtet verschoben. Dadurch ergibt sich ein von Null verschiedener Winkel **(ϑ) 108** zwischen dem Verbindungsvektor **(r) 107** und der Orientierung des äußeren Magnetfeldes **(B) 109**. Die Größe des Winkels (ϑ) **108** entscheidet über die Kopplungsstärke **(J)** zwischen benachbarten Fullerenen **104 /104',** die damit einstellbar ist.

In der **Figur 2c** ist eine Änderung der Kopplungsstärke **(J)** der Qubits **106** durch eine Verdrehung oder Verkippung des äußeren Magnetfeldes **(B) 109** gegenüber dem Substrat **101** dargestellt. Anstelle der Verkippung des Substrats **101** zusammen mit den Fullerenen **104** gegenüber dem äußeren Feld **109** gemäß **Figur 2a** wird hier das äußere Magnetfeld **(B) 109** um einen Winkel (β) **203** gekippt. Der sich dabei ergebende Winkel (ϑ) **108** zwischen dem Verbindungsvektor **(r) 107** und der Orientierung des äußeren Magnetfeldes **(B) 109** kann wie oben zur Steuerung der Kopplung **(J)** eingesetzt werden.

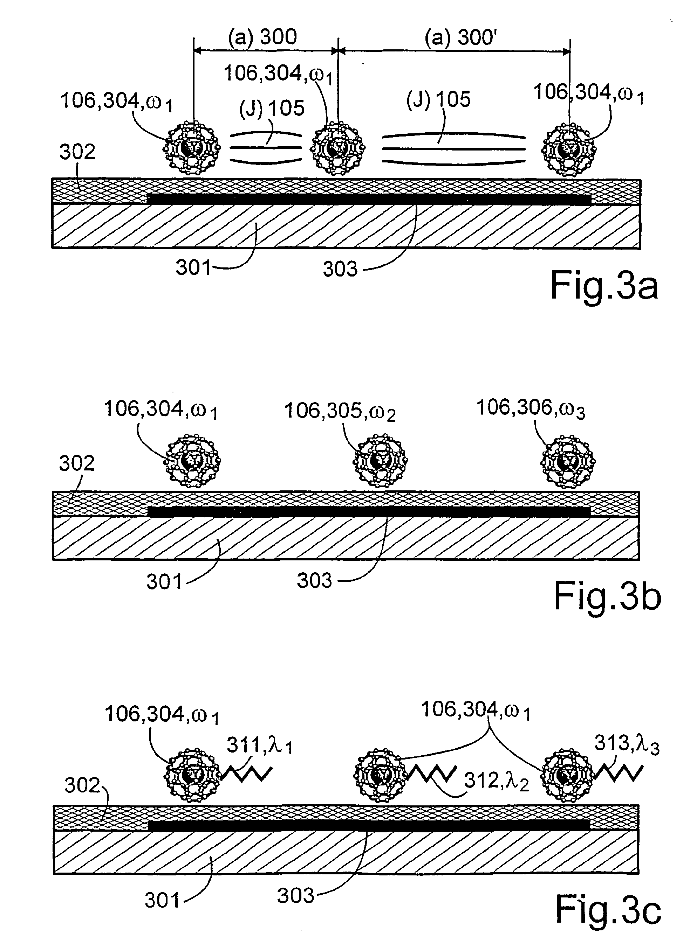

In den **Figuren 3a, 3b und 3c** werden verschiedene Realisierungsmöglichkeiten für Adressier-Steuerzugänge zur gezielten Adressierung der Qubits **106** gezeigt. Dabei sind jeweils über einem Substrat **301** getrennt durch eine Oxidschicht **302** endohedrale Fullerene **304, 305, 306** angeordnet. Unter diesen befindet sich jeweils in der Oxidschicht **302** eine für alle Fullerene **304**, **305, 306** gemeinsame flächige Adressier-Elektrode **303** als mögliche Realisierung eines Adressier-Steuerzuganges im Zusammenwirken mit bestimmten Eigenschaften der Qubits **106**.

Die **Figur 3a** zeigt die Verwendung einer gemeinsamen Adressier-Elektrode **303** für mehrere Qubits **106,** die sich in ihrer statischen Resonanzfrequenz (ω) unterscheiden, indem die Abstände **(a) 300/300'** zwischen den Fullerenen **304** verschieden sind. Die Fullerene 304 können in ihrer Resonanzfrequenz (ω) unterschieden werden, da aufgrund unterschiedlicher Abstände **(a) 300/300'** eine unterschiedliche Dipol-Dipol-Wechselwirkung **(J) 105** mit den Nachbaratomen vorliegt, die die Resonanzfrequenz (ω) jedes Fullerens **304** auf eindeutige Weise verschiebt.

In der **Figur 3b** ist die Verwendung einer gemeinsamen Adressier-Elektrode 303 für mehrere Qubits **106** dargestellt, die sich in ihrer statischen Resonanzfrequenz (ω) unterscheiden, indem die eingeschlossenen Atome oder die Fullerenkäfige verschieden sind. Die Fullerene **304, 305, 306** können in ihrer Resonanzfrequenz (ω₁, ω₂, ω₃) unterschieden werden, da sie unterschiedliche Atome enthalten (z.B. Stickstoff **N** oder Phosphor **P** in **C**₆₀) oder die Atome sich in unterschiedlichen Käfigen befinden (z.B. Stickstoff N in **C₆₀** oder **C₇₀**).

Die **Figur 3c** zeigt die Verwendung einer gemeinsamen Adressier-Elektrode **303** für mehrere Qubits **106,** die sich in ihrer statischen Resonanzfrequenz (ω) unterscheiden, indem an einem endohedralen Fulleren **304** gleicher Sorte unterschiedliche Addenden **311, 312, 313** angebracht sind. Die Fullerene **304** können in ihrer Resonanzfrequenz (ω) unterschieden werden, da sie mit unterschiedlichen Addenden **311, 312, 313** versehen sind. Diese Addenden **311, 312, 313** können sich im dargestellten Ausführungsbeispiel durch ihre Photoempfindlichkeit (Absorptionsmaximum bei λ₁, λ₂, λ₃) unterscheiden und damit durch farbiges Licht selektiv angesprochen werden, sodass die Fullerene **304** entsprechend adressierbar sind. Derartig unterschiedlich farbsensitive Fullerene können dann beispielsweise in Gruppen mit gleicher Farbsensitivität auf dem Substrat quadratisch angeordnet sein, sodass entsprechende Adressbereiche entstehen (in der **Figur 3c** nicht dargestellt). Nach Lichtabsorption kann insbesondere ein Elektron auf den Fullerenkäfig **304** übertragen werden, der die ESR-Frequenz verändert. Bei einer optischen Schaltung des Adressier-Steuerzugangs durch Elektronentransfer dient die Adressier-Elektrode 303 dann der Steuerung des Ladungsabflusses. Diese kann auch ohne elektrische Funktionsweise realisiert werden, wenn die Verweildauer der Elektronen auf den Fullerenen **304** auf andere Weise kontrolliert wird, z.B. durch chemische Manipulation der Adressier-Elektrode **303.**

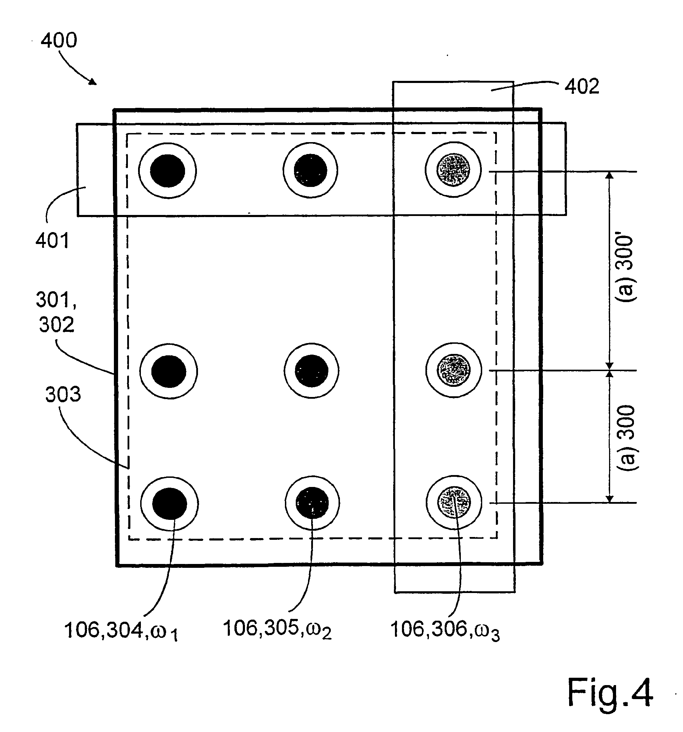

In der **Figur 4** ist eine Draufsicht auf einen Elektronenspin-Quantencomputer **400** nach den Realisierungsvorgaben gemäß der **Figuren 3a** und **3c** dargestellt. Auf der Oxidschicht **302** sind die endohedralen Fullerene **304, 305, 306** verschiedenen Typs in Reihen **401** und Spalten **402** angeordnet. Innerhalb einer Reihe **401** sind die Fullerene **304, 305, 306** durch ihren Typ, innerhalb einer Spalte **402** durch ihren Abstand **(a) 300/300'** voneinander unterschieden. Beide Parameter (Typ und Abstand) geben statisch eine Unterscheidbarkeit der Qubits **106** (Elektronenspins) der in den Fullerenen **304, 305, 306** eingeschlossenen Atome hinsichtlich ihrer Resonanzfrequenz (ω₁, ω₂, ω₃) und ihrer Kopplung **(J)** vor. Durch die unterschiedliche Resonanzfrequenz (ω₁, ω₂, ω₃) der Qubits **106** braucht der Adressier-Steuerzugang, der in diesem Fall durch die flächige, in die Oxidschicht **302** eingelagerte Elektrode **303** realisiert ist, nur auf alle Qubits **106** gemeinsam zu wirken.

### Bezugszeichenliste

- **100**: Elektronenspin-Quantencomputer
- **101**: Substrat
- **102**: Oxidschicht
- **103**: Adressier-Elektrode
- **104**: endohedrales Fulleren
- **104'**: ausgelenktes endohedrales Fulleren
- **105**: Dipol-Dipol-Wechselwirkung / elektromagnetische Kopplung (J)
- **106**: Elektronenspin (Qubit)
- **107**: Abstandsvektor (r)
- **108**: Winkel (ϑ)
- **109**: äußeres Magnetfeld (B)
- **201**: Verkippung / Verdrehung
- **202**: Verschiebungsvektor (d)
- **203**: Winkel (β)

- **300**: Abstand **(a)**
- **300'**: Abstand **(a)**
- **301**: Substrat
- **302**: Oxidschicht
- **303**: Adressier-Elektrode
- **304**: endohedrales Fulleren mit Resonanzfrequenz ω₁
- **305**: endohedrales Fulleren mit Resonanzfrequenz ω₂
- **306**: endohedrales Fulleren mit Resonanzfrequenz ω₃
- **311**: photoempfindlicher Addend mit Absorptionsmaximum bei λ₁
- **312**: photoempfindlicher Addend mit Absorptionsmaximum bei λ₂
- **313**: photoempfindlicher Addend mit Absorptionsmaximum bei λ₃

- **400**: Elektronenspin-Quantencomputer
- **401**: Reihe
- **402**: Spalte

## Patentansprüche

1. Verfahren zur Verarbeitung von quantenmechanischen Informationseinheiten durch deren Kodierung in der Spinstellung, die in einem äußeren Magnetfeld durch eingestrahlte elektromagnetische Pulse in Resonanzfrequenz beeinflussbar ist, von lokal einem Substrat zugeordneten, adressierbaren Spins mit einer Steuerung der Resonanzfrequenz der einzelnen Spins und der elektromagnetischen Kopplung zwischen benachbarten Spins,
**dadurch gekennzeichnet, dass**
zur Informationsverarbeitung der adressierbare Elektronenspin (106) ungebundener Einschlussatome im Käfiginnenraum von endohedralen Fullerenen (104) genutzt wird, der mit den Elektronenspins (106) benachbarter Einschlussatome über magnetische Dipol-Dipol-Wechselwirkung (105) in Kopplung steht, und dass die Steuerung der Resonanzfrequenz (ω) der Elektronenspins (106) durch einen kontrollierten Elektronentransfer zum oder vom Käfig der endohedralen Fullerene (104) mit einstellbarer Verweildauer und/oder die Steuerung der elektromagnetischen Kopplung (J) durch eine kontrollierte Winkeländerung (ϑ) (108) zwischen der Orientierung des äußeren Magnetfeldes (B) (109) und dem Verbindungsvektor (r) (107) benachbarter Fullerene (104) erfolgt.

2. Verfahren nach Anspruch 1,
**dadurch gekennzeichnet, dass**
die Steuerung in einem periodischen Arbeitstakt erfolgt.

3. Verfahren nach Anspruch 1 oder 2,
**dadurch gekennzeichnet, dass**
die Steuerung der Resonanzfrequenzen (ω₁, ω₂, ω₃) der einzelnen Elektronenspins (106) ohne zusätzliche äußere Maßnahmen durch Wahl der Art, Variation oder chemischen Modifikation der endohedralen Fullerene (304, 305, 306) sowie der Art der Einschlussatome und/oder durch Wahl der lokalen Zuordnung der benachbarten Fullerene (304, 305, 306) zur statischen Unterscheidung der einzelnen Elektronenspins (106) erfolgt.

4. Verfahren nach einem der Ansprüche 1 bis 3,
**dadurch gekennzeichnet, dass**
die Steuerung der Resonanzfrequenzen der einzelnen Elektronenspins durch zusätzliche äußere Maßnahmen in Form einer elektronischen Kontrolle des Elektronentransfers, einer chemischen Beeinflussung der Verweildauer der transferierten Elektronen auf dem Käfig der Fullerene und/oder einer optisch selektiven Anregung des Elektronentransfers zur dynamischen Unterscheidung der einzelnen Elektronenspins erfolgt.

5. Verfahren nach Anspruch 3 und 4,
**dadurch gekennzeichnet, dass**
mehrere statisch unterscheidbare Elektronenspins gemeinsam zumindest einer Maßnahme zur dynamischen Unterscheidung unterzogen werden.

6. Verfahren nach Anspruch 4 oder 5,
**dadurch gekennzeichnet, dass**
die Elektronen für den Elektronentransfer unter Anlegen eines elektrischen Steuerfeldes aus der Umgebung der endohedralen Fullerene stammen / in diese zurückgeleitet werden.

7. Verfahren nach Anspruch 4 oder 5,
**dadurch gekennzeichnet, dass**
die Elektronen für den Elektronentransfer unter Anlegen eines elektrischen Steuerfeldes aus Donatormolekülen auf Polymerbasis stammen / in diese zurückgeleitet werden, die an die Fullerene gekoppelt sind.

8. Verfahren nach Anspruch 4 oder 5,
**dadurch gekennzeichnet, dass**
die Elektronen für den Elektronentransfer unter Anlegen eines optischen Steuerfeldes zur optischen Anregung aus lichtempfindlichen, insbesondere farbempfindlichen Donatormolekülen (311, 312, 313) auf Polymerbasis stammen, die an die Fullerene (304) gekoppelt sind

9. Verfahren nach einem der Ansprüche 1 bis 8,
**dadurch gekennzeichnet, dass**
durch Kombination unterschiedlicher Einstellformen für die Resonanzfrequenzen mit und ohne zusätzlich äußere Maßnahmen differenzierte und komplexe Protokolle zur Verarbeitung von quantenmechanischen Informationseinheiten erstellbar sind.

10. Verfahren nach einem der Ansprüche 1 bis 9,
**dadurch gekennzeichnet, dass**
die Steuerung der elektromagnetischen Kopplung (J) zwischen benachbarten Elektronenspins (106) durch eine kontrollierte Winkeländerung (ϑ) (108) zwischen der Orientierung des äußeren Magnetfeldes (B) (109) und dem Verbindungsvektor (r) (107) benachbarter Fullerene (104) in einem Winkelbereich zwischen 0° und 54,7° durch eine relative Lageveränderung einzelner oder in Gruppen zusammengefasster Fullerene (104) zum äußeren Magnetfeld (B) (109) erfolgt.

11. Verfahren nach Anspruch 10,
**dadurch gekennzeichnet, dass**
die kontrollierte Winkeländerung (ϑ) (108) in einem Winkelbereich von 45° ± 9,7° erfolgt.

12. Verfahren nach Anspruch 10 oder 11,
**dadurch gekennzeichnet, dass**
die relative Lageänderung durch Verkippung oder Änderung der effektiven Orientierung (β) (203) des äußeren Magnetfelds (B) (109), oder durch Verkippen (ϑ)(108) des Substrats (101), dem die endohedralen Fullerene (104) lokal zugeordnet sind, erfolgt.

13. Verfahren nach Anspruch 10 oder 11,
**dadurch gekennzeichnet, dass**
die relative Lageänderung durch Verschiebung (d) (202) einzelner oder zu Gruppen zusammengefasster endohedraler Fullerene (104, 104') entlang der Orientierung des äußeren Magnetfeldes (B) (109) erfolgt.

14. Anordnung in Form eines spinbasierten Quantencomputers zur Durchführung des Verfahrens nach einem der Ansprüche 1 bis 13 zur Verarbeitung von quantenmechanischen Informationseinheiten durch deren Kodierung in der Spinstellung, die in einem äußeren Magnetfeld durch eingestrahlte elektromagnetische Pulse in Resonanzfrequenz beeinflussbar ist, von lokal einem Substrat zugeordneten, adressierbaren Spins mit einer Steuerung der Resonanzfrequenz der einzelnen Spins und der elektromagnetischen Kopplung zwischen benachbarten Spins mit lokalen Adressier-Steuerzugängen zur Steuerung der Resonanzfrequenz der einzelnen Spins und lokalen Kopplungs-Steuerzugängen zur Steuerung der elektromagnetischen Kopplung zwischen benachbarten Spins,
**dadurch gekennzeichnet, dass**
die adressierbaren Spins von Elektronenspins (106) ungebundener Einschlussatome im Käfiginnenraum von endohedralen Fullerenen (104, 304, 305, 306) gleicher oder unterschiedlicher Ausführung gebildet werden, die unter Einbeziehung des Substrats (101, 301) mit einem vorgegebenen Abstand (a) (300,300') und einer relativen Lage zueinander in einer Matrix mit zwei- oder dreidimensionaler Ausprägung fest miteinander verbunden sind, und dass die Adressier- und/oder Kopplungs-Steuerzugänge (103, 303) konstruktiv entsprechend der gewählten Form der Steuerung der Resonanzfrequenz (ω)) der einzelnen Spins (106) und der elektromagnetischen Kopplung (J) zwischen benachbarten Spins (106) ausgeführt sind.

15. Anordnung nach Anspruch 14,
**dadurch gekennzeichnet, dass**
für die Steuerung der Resonanzfrequenzen der einzelnen Elektronenspins über Adressier-Steuerzugänge eine Steuerspannung angelegt wird, die zu einem Elektronentransfer auf das Fulleren aus dem Substrat oder aus einem Elektrolyten, der die Fullerene umgibt, führt.

16. Anordnung nach Anspruch 14,
**dadurch gekennzeichnet, dass**
für die Steuerung der Resonanzfrequenzen der einzelnen Elektronenspins durch einen Elektronentransfer aus Donatormolekülen auf Polymerbasis die Donatormoleküle durch direkte chemische Verbindung oder über Zuleitungen auf Polymerbasis mit den endohedralen Fullerenen verbunden sind und über Adressier-Steuerzugänge in Elektrodenform eine Steuerspannung angelegt ist.

17. Anordnung nach Anspruch 14,
**dadurch gekennzeichnet, dass**
für die Steuerung der Resonanzfrequenzen der einzelnen Elektronenspins (106) durch einen Elektronentransfer aus lichtempfindlichen Donatormolekülen (311, 312, 313) auf Polymerbasis die Donatormoleküle durch direkte chemische Verbindung oder über Zuleitungen auf Polymerbasis mit den endohedralen Fullerenen (304) verbunden sind und über Adressier-Steuerzugänge in Lichtquellenform ein Anregungslichtstrom erzeugt wird.

18. Anordnung nach einem der Ansprüche 14 bis 17,
**dadurch gekennzeichnet, dass**
bei statisch unterscheidbaren Elektronenspins ein gemeinsamer Adressier-Steuerzugang vorgesehen ist.

19. Anordnung nach einem der Ansprüche 14 bis 18,
**dadurch gekennzeichnet, dass**
die endohedralen Fullerene in Form von oligo- oder polymeren oder chemisch miteinander verknüpften, endohedralen Fullerensystemen mit definierten Dipolkopplungen strukturiert und in der Matrix angeordnet, insbesondere orientiert angeordnet sind.

20. Anordnung nach Anspruch 19,
**dadurch gekennzeichnet, dass**
die endohedralen Fullerene (304) in linearen Ketten (401, 402) mit regelmäßigem Abstand (a) zwischen den einzelnen Fullerenen (304), an den Knotenpunkten oder einzeln oder in linearen oder gekoppelten Ketten entlang der Maschen von Gittern mit regelmäßiger Wabenstruktur in einer flächigen Matrix auf dem Substrat (301) angeordnet sind.

21. Anordnung nach Anspruch 19 oder 20,
**dadurch gekennzeichnet, dass**
für die Steuerung der elektromagnetischen Kopplung zwischen benachbarten Elektronenspins durch Verkippung (β, ϑ) des äußeren Magnetfeldes (B) (109) oder des Substrats (101), dem die endohedralen Fullerene (104) lokal zugeordnet sind, die Kopplungs-Steuerzugänge in Form entsprechender Kippmechanismen, insbesondere beim Verkippen von Substratbereichen in Form von Flüssigkristallen, ausgebildet sind

22. Anordnung nach Anspruch 19 oder 20,
**dadurch gekennzeichnet, dass**
für die Steuerung der elektromagnetischen Kopplung (J) zwischen benachbarten Elektronenspins (106) durch Änderung der effektiven Orientierung des äußeren Magnetfelds (B) (109) die Kopplungs-Steuerzugänge als bezüglich des quantisierenden Hauptfeldes orthogonale Zusatzfelder ausgebildet sind.

23. Anordnung nach Anspruch 19 oder 20,
**dadurch gekennzeichnet, dass**
für die Steuerung der elektromagnetischen Kopplung (J) zwischen benachbarten Elektronenspins (106) durch Verschiebung (d) (203) einzelner oder zu Gruppen zusammengefasster endohedraler Fullerene (104, 104') entlang der Orientierung des äußeren Magnetfeldes (B) (109) die Kopplungs-Steuerzugänge, die mit einer entsprechenden Kraftübertragung auf die Fullerene oder Fullerengruppen einwirken, in Form von piezoelektrischen oder vibrierenden Elementen oder Bauelementen zur Erzeugung von Oberflächenschallwellen ausgeführt sind.

24. Anordnung nach einem der Ansprüche 19 bis 23,
**dadurch gekennzeichnet, dass**
bei statisch unterscheidbaren elektromagnetischen Kopplungen zwischen benachbarten Elektronenspins jeweils ein einzelner, diese gemeinsam überdeckender Kopplungs-Steuerzugang in einer der gewählten Steuerungsform für die Kopplung entsprechenden Ausführungsform vorgesehen ist.

## Claims

1. Method of processing quantum mechanical data units encoded in a spin state which may be affected in an external magnetic field by irradiation with resonant electromagnetic pulses , of addressable spins locally associated with a substrate and provided with a control of the resonance frequency of the individual spins and of the electromagnetic coupling between neighbouring spins,
**characterised by** the fact that
for the data processing the addressable electron spin (106) of free atoms enclosed in the interior of the cage of endohedral fullerenes (104) is used which by magnetic dipole-dipole interaction (105) is coupled to the electron spins (106) of neighbouring enclosed atoms, and that the control of the resonance frequency (ω) of the electron spins (106) takes place by controlled electron transfer with adjustable dwell time to or from the cage of the endohedral fullerenes (104) and/or that the control of the electromagnetic coupling (J) takes place by a controlled change of angle (ϑ) (108) between the orientation of the external magnetic field (B) (109) and the connection vector (r) (107) of neighbouring fullerenes (104).

2. Method according to claim 1,
**characterised by** the fact that
the control takes place in a periodic clock rate.

3. Method according to claim 1 or 2,
**characterised by** the fact that
the control of the resonance frequency (ω₁, ω₂, ω₃) of the individual electron spins (106) takes place without additional external means by selection of the type, variation or chemical modification of the endohedral fullerenes (304, 305, 306) as well as by the type of the enclosed atoms and/or by selection of the local order of neighbouring fullerenes (304, 305, 306) for the static distinction of the individual electron spins (106).

4. Method according to claim 1 to 3,
**characterised by** the fact that
the control of the resonance frequency of the individual electron spins is carried out by additional external measures such as an electronic control of the electron transfer, by a chemical fine-tuning of the dwell time of the transferred electron on the cage of the fullerenes and/or by an optical selective excitation of the electron transfer for dynamically distinguishing the individual electron spins.

5. Method according to claim 3 and 4,
**characterised by** the fact that
several statically distinguishable electron spins are in common subjected at least to one measure for the dynamic distinction.

6. Method according to claim 4 or 5,
**characterised by** the fact that
the electrons for the electron transfer by application of an electric control field originate from or are returned to the environment of the endohedral fullerenes.

7. Method according to claim 4 or 5,
**characterised by** the fact that
the electrons for the electron transfer by application of an electric control field originate from or are returned to polymer based donor molecules.

8. Method according to claim 4 or 5,
**characterised by** the fact that
the electrons for the electron transfer by application of an optical control field for the optical excitation originate from light sensitive, especially color sensitive polymer based donor molecules (311, 312, 313) coupled to the fullerenes (304).

9. Method according to claim 1 to 8,
**characterised by** the fact that
differentiated and complex protocols for processing quantum mechanical data units may be established by combining different kinds of resonance frequency adjustments with and without additional external measures.

10. Method according to claim 1 to 9,
**characterised by** the fact that
the control of the electromagnetic coupling (J) between neighbouring electron spins (106) is carried out by a controlled change of angle (ϑ) (108) between the orientation of the external magnetic field (B) (109) and the connection vector (r) (107) of neighbouring fullerenes (104) in an angular range between 0° and 54.7° by a change in position of individual or grouped fullerenes (104) relative to the external magnetic field (B) (109).

11. Method according to claim 10,
**characterised by** the fact that
the controlled angular change (ϑ) (108) is carried out in an angular range of 45° ± 9.7°.

12. Method according to claim 10 or 11,
**characterised by** the fact that
the relative change in position is carried out by tilting or changing the effective orientation (β) (203) of the external magnetic field (B) (109) or by tilting (ϑ) (108) the substrate (101) with which the endohedral fullerenes (104) are locally associated.

13. Method according to claim 10 or 11,
**characterised by** the fact that
the relative change in position is carried out by shifting (d) 202) individual or grouped endohedral fullerenes (104, 104') along the orientation of the external magnetic field (B) (109).

14. Assembly structured as a spin based quantum computer for practicing the method of claim 1 to 13 for the processing of quantum mechanical data units by their coding in the spin state which may be affected in an external magnetic field by irradiation of resonant electromagnetic pulses, of addressable spins locally associated with a substrate with a control of the resonance frequency of the individual spins and the electromagnetic coupling between neighbouring spins with local addressing control accesses for controlling the resonance frequency of the individual spins and local coupling control accesses for controlling the electromagnetic coupling between neighbouring spins,
**characterised by** the fact that
the addressable spins are formed by electron spins (106) of free atoms enclosed in the interior of the cage of endohedral fullerenes (104, 304, 305, 306) of the same or different structure which - including the substrate (101, 301) - are rigidly connected to each other in a matrix of two- or three-dimensional character with a predetermined spacing (a) (300, 300') and that the addressing and/or coupling control accesses (103, 303) are structurally formed in correspondence with the selected kind of control of the resonance frequency (ω) of the individual spins (106) and the electromagnetic coupling (J) between neighbouring spins (106).

15. Assembly according to claim 14,
**characterised by** the fact that
a control voltage is applied by way of addressing control accesses for controlling the resonance frequencies of the individual electron spins, which control voltage results in an electron transfer to the fullerene from the substrate or from an electrolyte which is surrounding the fullerenes.

16. Assembly according to claim 14,
**characterised by** the fact that
for the control of the resonance frequencies of individual electron spins by an electron transfer from polymer based donor molecules the donor molecules are connected to the endohedral fullerenes by direct chemical bonding or by polymer based feed lines and that a control voltage is applied by way of addressing control accesses structured as electrodes.

17. Assembly according to claim 14,
**characterised by** the fact that
for the control of the resonance frequencies of individual electron spins (106) by an electron transfer from polymer based light sensitive donor molecules (311, 312, 313) the donor molecules are connected by direct chemical bonding or by polymer based feed lines with the endohedral fullerenes (104) and that an excitation light current is generated by way of the addressing control accesses structured as a light source.

18. Assembly according to claim 14 to 17,
**characterised by** the fact that
statically distinguishable electron spins provide a common addressing control access.

19. Assembly according to claim 14 to 18,
**characterised by** the fact that
the endohedral fullerenes structured as oligomeric, polymeric or chemically bonded systems of endohedral fullerenes are structured with defined dipole couplings and are arranged in the matrix, particularly in an oriented manner.

20. Assembly according to claim 19,
**characterised by** the fact that
the endohedral fullerenes (304) are arranged as linear chains (401, 402) with uniform spacings (a) between individual fullerenes (304), at the junctions or individually or in linear or coupled chains along the meshes of grids of uniform honeycomb structure in a two-dimensional matrix on the substrate (301).

21. Assembly according to claim 19 or 20,
**characterised by** the fact that
for controlling the electromagnetic coupling between neighbouring electron spins by tilting (β, ϑ) of the external magnetic field (B) (109) or of the substrate (101) with which the endohedral fullerenes are locally associated, the coupling control accesses are structured as corresponding tilting mechanisms, particularly when tilting of substrate areas structured as liquid crystals.

22. Assembly according to claim 19 or 20,
**characterised by** the fact that
for controlling the electromagnetic coupling (J) between neighbouring electron spins (106) by changing the effective orientation of the external magnetic field (B) (109), the coupling control accesses are realised as additional fields orthogonal with respect to the quantizing main field.

23. Assembly according to claim 19 or 20,
**characterised by** the fact that
for controlling the electromagnetic coupling (J) between neighbouring electron spins (106) by shifting (d) (203) of individual or grouped endohedral fullerenes (104, 104') along the orientation of the external magnetic field (B) (109) the coupling control accesses which affect the fullerenes or group of fullerenes are structured as piezoelectric or vibrating elements or as devices for generating surface acoustic waves.

24. Assembly according to claim 19 to 23,
**characterised by** the fact that
with statically distinguishable electromagnetic couplings between neighbouring electron spins there is provided for each such couple an individual coupling control access structured to correspond to the selected kind of coupling control.

## Revendications

1. Procédé pour le traitement d'unités d'informations en mécanique quantique par leur codage dans la position de spin pouvant être influencée dans un champ magnétique extérieur par des impulsions électromagnétiques rayonnées dans la fréquence de résonance, dont les spins adressables associés localement à un substrat ont une commande de la fréquence de résonance des spins individuels et du couplage électromagnétique entre des spins voisins,
**caractérisé en ce que**
pour le traitement des informations, on utilise le spin d'électrons adressable (106) d'atomes incluants libres qui, à l'intérieur de la cage de fullerènes endohédriques (104), est couplé aux spins d'électrons (106) d'atomes incluants voisins par une interaction magnétique dipôle-dipôle (105), et la commande de la fréquence de résonance (ω) des spins d'électrons (106) se fait par un transfert d'électrons contrôlés vers ou depuis la cage des fullerènes endohédriques (104) avec une durée de séjour réglable, et/ou la commande du couplage électromagnétique (J) se fait par une modification angulaire contrôlée (θ) (108) entre l'orientation du champ magnétique extérieur (B) (109) et le vecteur de liaison (r) (107) de fullerènes (104) voisins.

2. Procédé selon la revendication 1,
**caractérisé en ce que**
la commande a lieu dans un cycle périodique.

3. Procédé selon la revendication 1 ou 2,
**caractérisé en ce que**
la commande des fréquences de résonance (ω1, ω2, ω3) des différents spins d'électrons (106) se fait sans mesures extérieures supplémentaires par le choix du type, de la variation ou de la modification chimique des fullerènes endohédriques (304, 305, 306) ainsi que du type d'atomes incluants et/ou par le choix de l'attribution locale des fullerènes voisins (304, 305, 306) pour une distinction statique des différents spins d'électrons (106).

4. Procédé selon l'une quelconque des revendications 1 à 3,
**caractérisé en ce que**
la commande des fréquences de résonance des différents spins d'électrons se fait par des mesures extérieures supplémentaires sous la forme d'un contrôle électronique du transfert d'électrons, d'une influence chimique de la durée de séjour des électrons transférés sur la cage des fullerènes, et/ou d'une excitation optiquement sélective du transfert d'électrons pour la distinction dynamique des différents spins d'électrons.

5. Procédé selon la revendication 3 ou 4,
**caractérisé en ce que**
plusieurs spins d'électrons statiquement différenciables subissent conjointement au moins une mesure pour la distinction dynamique.

6. Procédé selon la revendication 4 ou 5,
**caractérisé en ce que**
pour le transfert d'électrons par application d'un champ de commande électrique, les électrons proviennent de l'environnement des fullerènes endohédriques, ou sont ramenés à cet environnement.

7. Procédé selon la revendication 4 ou 5,
**caractérisé en ce que**
pour le transfert d'électrons par application d'un champ de commande électrique, les électrons proviennent de molécules donneuses à base de polymère, couplées aux fullerènes, ou sont ramenés dans celles-ci.

8. Procédé selon la revendication 4 ou 5,
**caractérisé en ce que**
pour le transfert d'électrons par application d'un champ de commande optique pour l'excitation optique, les électrons proviennent de molécules donneuses (311, 312, 313) à base de polymère, sensibles à la lumière et notamment aux couleurs et couplées aux fullerènes (304).

9. Procédé selon l'une quelconque des revendications 1 à 8,
**caractérisé en ce que**
la combinaison de différentes formes de réglage pour les fréquences de résonance avec ou sans mesures extérieures supplémentaires permet de créer des protocoles différenciés et complexes pour le traitement d'unités d'informations en mécanique quantique.

10. Procédé selon l'une quelconque des revendications 1 à 9,
**caractérisé en ce que**
la commande du couplage (J) électromagnétique entre des spins d'électrons voisins (106) se fait par une modification angulaire contrôlée (θ) (108) entre l'orientation du champ magnétique extérieur (B) (109) et le vecteur de liaison (r) (107) de fullerènes voisins (104) dans une plage angulaire comprise entre 0° et 54,7° par une modification relative de la position de fullerènes individuels (104) ou réunis en groupes pour le champ magnétique extérieur (B) (109).

11. Procédé selon la revendication 10,
**caractérisé en ce que**
la modification angulaire contrôlée (θ) (108) se fait dans une plage angulaire de 45° ± 9,7°.

12. Procédé selon la revendication 10 ou 11,
**caractérisé en ce que**
la modification relative de la position a lieu en basculant ou en modifiant l'orientation effective (β) (203) du champ magnétique extérieur (B) (109) ou par le basculement (θ) (108) du substrat (101) auquel sont associés localement les fullerènes endohédriques (104).

13. Procédé selon la revendication 10 ou 11,
**caractérisé en ce que**
la modification relative de la position se fait par le déplacement (d) (202) de différents fullerènes (104, 104') endohédriques individuels ou réunis en groupe le long de l'orientation du champ magnétique extérieur (B) (109).

14. Dispositif sous la forme d'un ordinateur quantique basé sur des spins pour réaliser le procédé selon l'une quelconque des revendications 1 à 13, pour le traitement d'unités d'informations en mécanique quantique par leur codage dans la position de spin pouvant être influencée dans un champ magnétique extérieur par des impulsions électromagnétiques rayonnées dans la fréquence de résonance, dont les spins adressables associés localement à un substrat ont une commande de la fréquence de résonance des spins individuels et du couplage électromagnétique entre des spins voisins, avec des accès de commande d'adressage locaux pour la commande de la fréquence de résonance des différents spins et des accès de commande de couplage locaux pour la commande du couplage électromagnétique entre des spins voisins,
**caractérisé en ce que**
les spins adressables sont formés par des spins d'électrons (106) d'atomes incluants libres à l'intérieur de la cage de fullerènes endohédriques (104, 304, 305, 306), du même mode de réalisation ou d'un mode différent, reliés fixement les uns aux autres par l'insertion du substrat (101, 301) à une distance (a) donnée (300, 300') et à une position relative l'un par rapport à l'autre dans une matrice avec une empreinte 2D ou 3D, et les accès de commande d'adressage et/ou de couplage (103, 303) sont réalisés de manière constructive en fonction de la forme choisie de la commande de la fréquence de résonance (ω) des différents spins (106) et du couplage électromagnétique (J) entre des spins voisins (106).

15. Dispositif selon la revendication 14,
**caractérisé en ce que**
pour la commande des fréquences de résonance des différents spins d'électrons par des accès de commande d'adressage, on applique une tension de commande conduisant à un transfert d'électrons sur le fullerène provenant du substrat ou d'un électrolyte entourant les fullerènes.

16. Dispositif selon la revendication 14,
**caractérisé en ce que**
pour la commande des fréquences de résonance des différents spins d'électron par un transfert d'électrons provenant des molécules donneuses à base de polymère, les molécules donneuses sont reliées aux fullerènes endohédriques par une liaison chimique directe ou par des lignes d'alimentation à base de polymère, et une tension de commande est appliquée par des accès de commande d'adressage en forme d'électrodes.

17. Dispositif selon la revendication 14,
**caractérisé en ce que**
pour la commande des fréquences de résonance des différents spins d'électrons (106) par un transfert d'électrons provenant des molécules donneuses à base de polymère, sensibles à la lumière (311, 312, 313), les molécules donneuses sont reliées aux fullerènes endohédriques (304) par une liaison chimique directe ou par des lignes d'alimentation à base de polymère, et un flux lumineux d'excitation est généré par des accès de commande d'adressage en forme de sources de lumière.

18. Dispositif selon l'une quelconque des revendications 14 à 17,
**caractérisé en ce que**
dans le cas de spins d'électrons statiquement différenciables, on a prévu un accès de commande d'adressage commun.

19. Dispositif selon l'une quelconque des revendications 14 à 18,
**caractérisé en ce que**
les fullerènes endohédriques sont structurés sous la forme de systèmes de fullerènes endohédriques reliés les uns aux autres chimiquement ou oligomères et/ou polymères avec des couplages dipôles définis et disposés dans la matrice, en étant notamment orientés.

20. Dispositif selon la revendication 19,
**caractérisé en ce que**
les fullerènes endohédriques (304) sont disposés dans des chaînes linéaires (401, 402) avec une distance régulière (a) entre les différents fullerènes (304), ou sur les noeuds soit individuellement, soit dans des chaînes linéaires ou couplées, le long des mailles de grilles avec une structure alvéolaire régulière dans une matrice plane sur le substrat (301).

21. Dispositif selon la revendication 19 ou 20,
**caractérisé en ce que**
pour la commande du couplage électromagnétique entre des spins d'électrons voisins par basculement (β,θ) du champ magnétique extérieur (B) (109) ou du substrat (101) auquel sont associés localement les fullerènes endohédriques (104), les accès de commande de couplage sont conçus sous la forme de mécanismes de basculement correspondants, notamment lors du basculement de zones de substrat sous la forme de cristaux liquides.

22. Dispositif selon la revendication 19 ou 20,
**caractérisé en ce que**
pour la commande du couplage électromagnétique (J) entre des spins d'électrons (106) voisins par modification de l'orientation efficace du champ magnétique extérieur (B) (109), les accès de commande de couplage sont des champs additionnels orthogonaux au champ quantique principal.

23. Dispositif selon la revendication 19 ou 20,
**caractérisé en ce que**
pour la commande du couplage électromagnétique (J) entre des spins d'électrons (106) voisins, par déplacement (d) (203) de fullerènes (104, 104') endohédriques seuls ou rassemblés en groupe, le long de l'orientation du champ magnétique (B) extérieur, les accès de commande exerçant une transmission de force correspondante sur les fullerènes ou les groupes de fullerènes sont réalisés en forme d'éléments ou de composants piézoélectriques ou vibratoires pour produire des ondes soniques de surface.

24. Dispositif selon l'une des revendications 19 à 23,
**caractérisé en ce qu'**
en cas de couplage électromagnétiques statiques différents entre les spins d'électrons, on prévoit chaque fois un accès de commande de couplage distinct, couvrant ceux-ci en commun, dans un des modes de réalisation correspondant à la forme de commande sélectionnée pour le couplage.
